# EUROPEAN PATENT APPLICATION

(11) **EP 3 432 366 A1**
(43) Date of publication of application: **23.01.2019**
(21) Application number: 18731951.2
(22) Date of filing: 21.05.2018
(51) Int. Cl.: H01L 31/044, H01L 31/05

(54) **SOLAR CELL MODULE AND SOLAR CELL PANEL**

(30) Priority: 19.05.2017 CN 201720562480 U
(71) Applicant: Miasole Photovoltaic Technology Co., Ltd., Beijing (CN)
(72) Inventor: YANG, Sheng, Beijing 100072 (CN); SUN, Shiyang, Beijing 100072 (CN); ZHANG, Tieyi, Beijing 100072 (CN); LIU, Honggang, Beijing 100072 (CN); WEN, Zhenxing, Beijing 100072 (CN)
(74) Representative: Cabinet Beau de Loménie
(86) International application number: PCT/CN2018/087589
(87) International publication number: WO 2018/210348

(57) **Abstract**

The application discloses a solar cell component including at least two chip sets connected in series, wherein each chip set includes a plurality of chip units connected in parallel and a bypass diode connected in parallel with the chip units, each chip unit includes one or more photovoltaic chips connected in series, positive poles of the bypass diodes are connected with negative poles of the chip units, and negative poles of the bypass diodes are connected with positive poles of the chip units. The application further provides a solar panel with the solar cell component. The application not only can reduce the number of the bypass diodes, but also can improve economy of the product.

## Description

This application is filed based upon and claims priority to China Patent Application No. 201720562480.X, filed on May 19, 2017, which is hereby incorporated by reference in its entirety.

### Technical Field

The application relates to the field of solar cells, and more particularly relates to a solar cell component and a solar panel.

### Background Art

At present, energy crisis and environmental pollution become increasingly severe, and developing renewable clean energy becomes one of major strategic issues all over the world. Solar energy is unlimited, cleanest and greatest renewable energy. A solar cell is a device capable of directly converting optical energy into electric energy by means of a photoelectric effect or a photochemical effect, which is the most direct manner for utilization of the solar energy.

Along with widespread use of solar cells, some unfavorable factors influencing service life of a cell also arise, and one of them is hot spot. A hot spot of a solar cell refers to a dark spot formed by burnout due to an excessively high temperature of covered parts with temperature rises far higher than uncovered parts when a solar cell component is exposed to the sun and part of the component is covered and cannot work. The hot spot may damage the whole cell component to bring losses. Therefore, in the prior art, influence of a hot spot effect on a cell is usually reduced in a manner of adding bypass diodes.

Now most of solar cells are connected by connecting all chips in series or connecting the chips in series and then in parallel. A measure of connecting bypass diodes in parallel with the chips is usually adopted for preventing the hot spot effect. Connecting all the chips in series will cause many bypass diodes to be used and high cost; and when the chips are connected sequentially in series and then in parallel, the number of the bypass diodes may be reduced, but a plurality of chips share the same bypass diode, and if one chip does not work or is covered, it may influence work of the other chips, so that economic benefits are poor.

### Summary of the Application

One aspect of the application provides a solar cell component, so as to reduce the number of bypass diodes and improve reliability of the component.

The other aspect of the application provides a solar panel, so as to prolong service life of the solar panel, reduce cost and improve economic benefits of the product.

To this end, the application provides the following technical solutions.
the application provides a solar cell component including at least two chip sets connected in series, wherein each chip set includes a plurality of chip units connected in parallel and a bypass diode connected in parallel with the chip units, each chip unit includes one or more photovoltaic chips connected in series, positive poles of the bypass diodes are connected with negative poles of the chip units, and negative poles of the bypass diodes are connected with positive poles of the chip units.

Preferably, the photovoltaic chip is any one of a Copper Indium Gallium Selenide (CIGS) thin film double-glazed module chip, a thin film solar cell chip, a crystalline silicon solar cell chip and an amorphous silicon solar cell chip.

Preferably, each chip set includes three chip units, and each chip unit includes two photovoltaic chips.

Preferably, there are 18 chip sets.

Preferably, a maximum reverse working current of each bypass diode is more than or equal to 15A.

The application further provides a solar panel including the foregoing solar cell component, a negative electrode and a positive electrode, wherein the negative electrode and the positive electrode are both arranged on lower surfaces of photovoltaic chips, or the negative electrode is arranged on upper surfaces of the photovoltaic chips, and the positive electrode is arranged on the lower surfaces of the photovoltaic chips;
the negative electrode is connected with a negative pole of the solar panel by a first conducting bar and a first bus-bar, the first conducting bar is arranged in a region of the solar cell component, and the first bus-bar is arranged on one side of an upper surface of the solar cell component;
the positive electrode is connected with an positive pole of the solar panel by a second conducting bar and a second bus-bar, the second conducting bar is arranged in the region of the solar cell component, and the second bus-bar is arranged on one side of a lower surface of the solar cell component and is arranged in an opposite direction or the same direction with the first bus-bar; it is necessary to note that "in the region of the solar cell component" may be explained as follows: the solar cell component is irradiated with incident light perpendicular to the solar cell component to obtain a shadow region, and then the first conducting bar and/or the second conducting bar are arranged in the shadow region; and
an insulating film is further placed between the first conducting bar and/or the second conducting bar and the solar cell component.

Preferably, adjacent chip sets are connected by metal sheets.

Preferably, bypass diodes connected in series in the adjacent chip sets are connected by connecting strips.

Preferably, the connecting strips are copper strips.

Preferably, the first conducting bar is connected with the first bus-bar in a welding manner; and the second conducting bar is connected with the second bus-bar in the welding manner.

According to the solar cell component and solar panel provided by embodiments of the application, the photovoltaic chips are grouped, series and parallel connection are combined by providing series connection within parallel connection and parallel connection within series connection, and the plurality of chip units connected in parallel in each chip set share the same bypass diode, so that the number of the bypass diodes is greatly reduced, and it will not only effectively reduce cost, but also improve economic benefits.

### Brief Description of the Drawings

In order to describe the technical solutions in the embodiments of the present application or the prior art, the accompanying drawings required to be used in the embodiments will be simply introduced below. Obviously, the accompanying drawings described below are only some embodiments recorded in the application. Those of ordinary skilled in the art may further obtain other accompanying drawings according to these accompanying drawings.
Fig. 1 is a schematic diagram of a solar cell component according to an embodiment of the application;
Fig. 2 is a rear view of a solar panel according to an embodiment of the application; and
Fig. 3 is an enlarged schematic diagram of a connecting structure between bypass diodes and photovoltaic chips in a solar panel according to an embodiment of the application.

### Detailed Description of the Application

In order to make the solutions of the embodiments of the application understood by those skilled in the art better, the embodiments of the application will be further described below in combination with the accompanying drawings and implementation modes in detail.

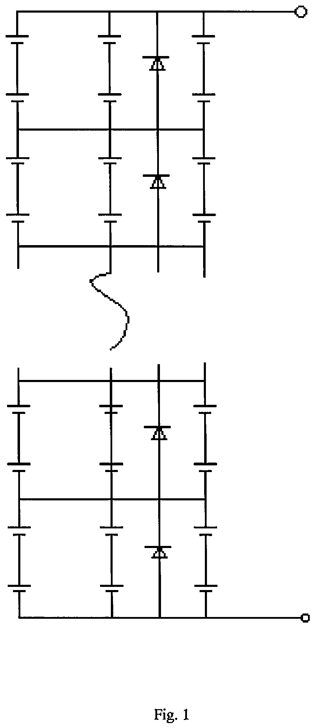

Fig. 1 is a schematic diagram of a solar cell component according to an embodiment of the application.

The solar cell component includes at least two chip sets connected in series. As shown in Fig. 1, each chip set includes a plurality of chip units connected in parallel and a bypass diode connected in parallel with the chip units, and each chip unit includes one or more photovoltaic chips connected in series. In Fig. 1, each chip unit includes two photovoltaic chips connected in series. Positive poles of the bypass diodes are connected with negative poles of the chip units, and negative poles of the bypass diodes are connected with positive poles of the chip units.

In the solar cell component provided by the application, the photovoltaic chips are connected in series at first to obtain the chip units, then the plurality of chip units are connected in parallel, the plurality of chip units being connected in parallel with only one bypass diode, to obtain the chip sets, and the plurality of chip sets are connected in series, so as to obtain the solar cell component of the application. As shown in Fig. 1, the first chip set includes a first chip unit, a second chip unit, a third chip unit and a first bypass diode, wherein each of the first chip unit, the second chip unit and the third chip unit includes two photovoltaic chips, the three chip units are connected in parallel, and the three chip units are all connected in parallel with the first bypass diode. If a "hot spot" phenomenon occurs to the photovoltaic chips of a certain chip unit in a chip set, the photovoltaic chips in the other chip units may work normally without influence of the "hot spot" phenomenon. For example, if the photovoltaic chips of the first chip unit in the first chip set are burned out, the photovoltaic chips of the second chip unit and the third chip unit may work normally without influence of the first chip unit. Normal work of the whole solar cell component is further ensured. Preferably, the number of the photovoltaic chips in a single chip unit may be two, three, four, five and the like, and further preferably, the number of the photovoltaic chips in a single chip unit is two; and the number of the chip units in a chip set may be two, three, four and the like, and further preferably, the number of the chip units in a chip set is three. Preferably, the numbers of the photovoltaic chips in different chip units in a chip set are the same. It is necessary to note that the number of the chip sets in the solar cell component is not specifically limited in the application. Preferably, the number of the chip sets in the solar cell component may be any numerical value in 2-20. During practical application, the number of practically required chip sets may be increased and decreased according to a requirement. When a plurality of such chip sets are required, the plurality of chip sets are sequentially connected in series, as shown in Fig. 1. Moreover, each chip unit may include only one photovoltaic chip, and may also include a plurality of photovoltaic chips connected in series. For example, three photovoltaic chips connected in series may form a chip unit, every three such chip units form a chip set, and 18 chip sets connected in series form a solar cell component. In addition, a working parameter of each bypass diode may also be set according to a practical application requirement, and for example, a maximum reverse working current is more than or equal to 15A. Of course, the foregoing chips connected in series and in parallel may be adaptively added and reduced according to different currents and voltages required to be provided according to the practical application, actual model numbers, parameters and the like of the bypass diodes may correspondingly be selected according to the practical requirement, and there are no limits made in the application.

Series and parallel connection are combined by providing series connection within parallel connection and parallel connection within series connection. By such a structural design, a plurality of chip units share the same bypass diode, and when any chip unit in each chip set is covered and cannot work, a hot spot effect may be avoided by the bypass diode in the chip set, so that the number of the bypass diodes is effectively reduced to reduce cost and improve reliability of the component.

In the solar cell component structure of the application, the photovoltaic chips may be applied to various types, for example, a CIGS thin film double-glazed module chip, a thin film solar cell chip, a crystalline silicon solar cell chip and an amorphous silicon solar cell chip.

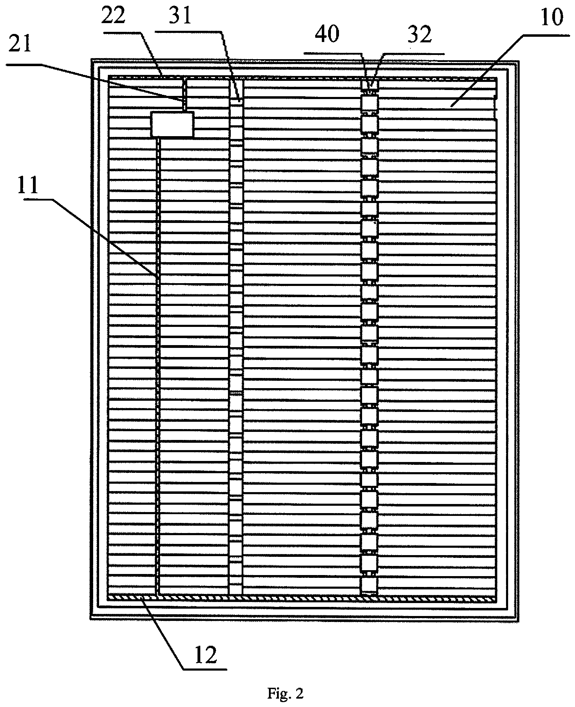

Correspondingly, the embodiments of the application further provide a solar panel with the foregoing solar cell component structure. Fig. 2 is a rear view of a structure of the solar panel.

The solar panel of the application includes the foregoing solar cell component, a negative electrode and a positive electrode, wherein the negative electrode and the positive electrode may both be arranged on lower surfaces of photovoltaic chips, or the negative electrode may be arranged on upper surfaces of the photovoltaic chips, and the positive electrode is arranged on the lower surfaces of the photovoltaic chips. In the structure shown in Fig. 2, the negative electrode and the positive electrode are both arranged on the lower surfaces of the photovoltaic chips. The negative electrode and the positive electrode are configured to extract currents.

As shown in Fig. 2, the negative electrode is connected with a negative pole of the solar panel by a first conducting bar 11 and a first bus-bar 12, the first conducting bar 11 is arranged in a region of the solar cell component, and the first bus-bar 12 is arranged on one side of an upper surface of the solar cell component; and the positive electrode is connected with an positive pole of the solar panel by a second conducting bar 21 and a second bus-bar 22, the second conducting bar 21 is arranged in the region of the solar cell component, and the second bus-bar 22 is arranged on one side of a lower surface of the solar cell component and is arranged in an opposite direction or the same direction with the first bus-bar 21.

It is necessary to note that, during practical application, the first conducting bar 11 may be arranged on the upper surfaces of the photovoltaic chips and may also be arranged on the lower surfaces of the photovoltaic chips, and the second conducting bar 21 may be arranged on the lower surfaces of the photovoltaic chips. Correspondingly, for avoiding contact between the conducting bars and the photovoltaic chips, an insulating film may be placed between the first conducting bar and/or the second conducting bar and the solar cell component.

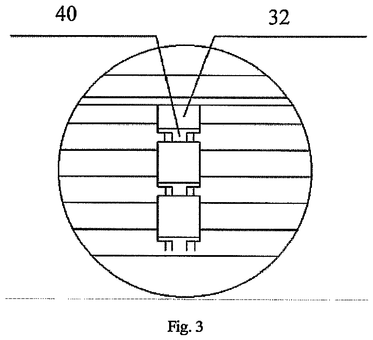

As mentioned above, there may be a plurality of chip sets according to the application requirement, and under such a circumstance, adjacent chip sets may be connected by metal sheets 31, as shown in Fig. 2. Similarly, bypass diodes 40 in the adjacent chip sets are connected by metal sheets 32 with the photovoltaic chips electrically connected therewith, as shown in Fig. 3.

In addition, the bypass diodes connected in series in the adjacent chip sets may be connected by connecting strips (for example, copper strips).

It is necessary to note that the first conducting bar 11 may be connected with the first bus-bar 12 in a welding manner and the second conducting bar 21 may also be connected with the second bus-bar 22 in the welding manner.

According to the solar cell component and solar panel provided by the embodiments of the application, the photovoltaic chips are grouped, series and parallel connection are combined by providing series connection within parallel connection and parallel connection within series connection, and the plurality of chip units connected in parallel in each chip set share the same bypass diode, so that the number of the bypass diodes is greatly reduced, and it will not only effectively reduce cost, but also improve economic benefits.

The embodiments of the application are introduced above in detail. The application is elaborated with specific implementation modes in the text, and the above descriptions about the embodiments are merely adopted to help the design of the application to be understood. In addition, those of ordinary skilled in the art may make variations to the specific implementation mode and the scope of application according to the concept of the application. From the above, the contents of the description should not be understood as limits to the application.

## Claims

1. A solar cell component, **characterized by** comprising at least two chip sets connected in series, wherein each chip set comprises a plurality of chip units connected in parallel and a bypass diode connected in parallel with the chip units, each chip unit comprises one or more photovoltaic chips connected in series, positive poles of the bypass diodes are connected with negative poles of the chip units, and negative poles of the bypass diodes are connected with positive poles of the chip units.

2. The solar cell component of claim 1, **characterized in that** the photovoltaic chip is any one of a Copper Indium Gallium Selenide thin film double-glazed module chip, a thin film solar cell chip, a crystalline silicon solar cell chip and an amorphous silicon solar cell chip.

3. The solar cell component of claim 1, **characterized in that** each chip set comprises three chip units, and each chip unit comprises two photovoltaic chips.

4. The solar cell component of claim 3, **characterized in that** there are 18 chip sets.

5. The solar cell component of claim 4, **characterized in that** a maximum reverse working current of the bypass diode is more than or equal to 15A.

6. A solar panel, **characterized by** comprising the solar cell component of any one of claims 1-5, a negative electrode and a positive electrode, wherein
the negative electrode and the positive electrode are both arranged on lower surfaces of photovoltaic chips, or the negative electrode is arranged on upper surfaces of the photovoltaic chips, and the positive electrode is arranged on the lower surfaces of the photovoltaic chips;
the negative electrode is connected with a negative pole of the solar panel by a first conducting bar and a first bus-bar, and the positive electrode is connected with a positive pole of the solar panel by a second conducting bar and a second bus-bar; and an insulating film is further placed between the first conducting bar and/or the second conducting bar and the solar cell component.

7. The solar panel of claim 6, **characterized in that** the solar cell component is irradiated with incident light perpendicular to the solar cell component to obtain a shadow region, and the first conducting bar and/or the second conducting bar are arranged in the shadow region.

8. The solar panel of claim 6, **characterized in that** adjacent chip sets are connected by metal sheets.

9. The solar panel of claim 6, **characterized in that** bypass diodes of the adjacent chip sets are connected in series.

10. The solar panel of claim 9, **characterized in that** the bypass diodes connected in series in the adjacent chip sets are electrically connected by connecting strips.

11. The solar panel of claim 10, **characterized in that** the connecting strips are copper strips.

12. The solar panel of any one of claims 6-11, **characterized in that** the first conducting bar is connected with the first bus-bar in a welding manner; and the second conducting bar is connected with the second bus-bar in the welding manner.
